# EUROPÄISCHE PATENTSCHRIFT

(11) **EP 0 539 718 B1**
(45) Veröffentlichungstag und Bekanntmachung des Hinweises auf die Patenterteilung: **25.11.1998**
(21) Anmeldenummer: 92116082.6
(22) Anmeldetag: 21.09.1992
(51) Int. Cl.: H01L 29/74

(54) **Abschaltbares Leistungshalbleiter-Bauelement**
Turn-off power semi-conductor device
Dispositif semi-conducteur de puissance à extinction

(30) Priorität: 26.10.1991 DE 4135411
(43) Veröffentlichungstag der Anmeldung: 05.05.1993
(73) Patentinhaber: ASEA BROWN BOVERI AG, 5400 Baden (CH)
(72) Erfinder: Bauer, Friedhelm, Dr., CH-3063 Ittingen, (CH)

(56) Entgegenhaltungen:
- EP-A- 0 340 445
- EP-A- 0 409 010
- DE-A- 4 011 509
- US-A- 4 646 117
- PATENT ABSTRACTS OF JAPAN vol. 12, no. 476 (E-693)(3323) 13. Dezember 1988 & JP-A-63 194 366 ( TOSHIBA CORP ) 11. August 1988
- PATENT ABSTRACTS OF JAPAN vol. 12, no. 498 (E-698)(3345) 26. Dezember 1988 & JP-A-63 209 172 ( TOSHIBA CORP ) 30. August 1988
- P.TAYLOR 'Thyristor Design and Realization', 1987, J.WILEY, GREAT BRITAIN

## Beschreibung

### TECHNISCHES GEBIET

Die vorliegende Erfindung bezieht sich auf das Gebiet der Leistungselektronik. Sie betrifft ein abschaltbares Leistungshalbleiter-Bauelement nach dem Oberbegriff des ersten Anspruchs.

### STAND DER TECHNIK

Ein solches Bauelement in der speziellen Form eines MOS-gesteuerten Thyristors MCT ist z.B. aus dem Artikel von V. A. K. Temple, IEEE Trans. Electron Devices, Vo. ED-33, S.1609-1618 (1986), bekannt.

Bei der Anwendung in leistungselektronischen Schaltungen, insbesondere bei drehzahlgesteuerten Motorantrieben, wären wichtige Systemvereinfachungen durchführbar, wenn bei den verwendeten Leistungshalbleitern die Stromsteuerung, wie man sie derzeit vom GTO her kennt, durch eine Spannungssteuerung ersetzt werden könnte. Dieser Uebergang von Strom- zu Spannungssteuerung ist bei kleineren Leistungen mit dem Ersatz der herkömmlichen Bipolartransistoren durch die neu entwickelten IGBTs (Insulated Gate Bipolar Transistors) bereits vollzogen worden.

Bei grösseren Leistungen, die im wesentlichen den Thyristoren vorbehalten bleiben, sind seit längerer Zeit Bemühungen im Gange, durch die Entwicklung des MOS-gesteuerten Thyristors MCT (MOS Controlled Thyristor) den GTO in entsprechender Weise abzulösen. Bei einem solchen MCT, wie er in der eingangs genannten Druckschrift beschrieben wird, sind innerhalb einer herkömmlichen Vierschichtstruktur auf der Kathodenseite eine Vielzahl von MOS-gesteuerten Kurzschlüssen vorgesehen, welche zum Abschalten des Bauelements den Kathodenkontakt mit der kathodenseitigen Basisschicht kurzschliessen und damit den regenerativen Mechanismus des Thyristors unterbrechen können.

Bisher sind diese Bemühungen jedoch nicht sehr erfolgreich verlaufen, weil gerade auch grossflächige MCTs nach wie vor unter abträglichen inhomogenen Stromdichteverteilungen - insbesondere während der Abschaltphase - leiden. Derartige Inhomogenitäten führen auch gerade an der Peripherie der kathodenseitigen Bauelementstruktur zu Ueberhöhungen in der Stromdichte, die das Bauelement zerstören oder zumindest den regulären Betrieb beeinträchtigen können.

In den Japanischen Offenlegungsvorschrift JP 63-194366 wird nun versucht, die obigen Nachteile durch Anbringen eine p-dotierten Gebietes am Rand der Einheitszellen zu vermeiden. Diese p-dotierten Randkurzschlussgebiete können ausserdem noch mit MOS-gesteuerten Kurzschlüssen versehen werden. Diese bilden zusammen mit den übrigen Schichten eine IGBT-Struktur. IGBT-Strukturen neigen aber bekanntlich dazu, in Gegenwart hoher Stromdichten in einen parasitären Thyristor-artigen Betrieb (Latch-Up) zu fallen. Die hohen Stromdichten herrschen ja aber genau an der Kathodenperipherie, so dass die p-dotierten Randkurzschlussgebiete aufgrund der inhärenten Latch-Up-Problematik ihre Funktion überhaupt nicht ausüben können. Ausserdem ist die Struktur nicht ohne weiteres herstellbar, und es werden weitere Prozessschritte benötigt.

Weitere Bauelemente sind in den Dokumenten US-A-4 646 117 und JP-A-63 209 172 beschrieben.

### DARSTELLUNG DER ERFINDUNG

Es ist daher die Aufgabe der Erfindung, ein abschaltbares Leistungshalbleiter-Bauelement - insbesondere auch in Form eines MCT - zu schaffen, bei welchem die Randkurzschlussgebiete möglichst einfach und wenn möglich ohne Mehraufwand bei der Herstellung der Zellstruktur erzeugt werden können. Die Randkurzschlussgebiete sollen zudem in der Lage sein, mit hoher Effizienz Ladungsträger extrahieren zu können.

Die Aufgabe wird bei einem Bauelement der eingangs genannten Art durch die Merkmale des ersten Anspruchs gelöst.

Der Kern der Erfindung besteht darin, die Randkurzschlussgebiete höher dotiert sind als die zweite Basisschicht und in diese eingelassen sind sowie eine Vielzahl von insel- oder streifenförmigen Zellen bilden sowie dass sie höher dotiert sind als die zweite Basisschicht.

Die Erfindung zeichnet sich dadurch aus, dass
(a) das Bauelement als MOS-gesteuerter Thyristor MCT und die Einheitszellen jeweils als MCT-Zellen ausgebildet sind; wobei
(b) innerhalb jeder MCT-Zelle auf der Kathodenseite ein in die zweite Basisschicht eingelassenes Emittergebiet vom zweiten Leitfähigkeitstyp angeordnet ist, welches von der Kathodenfläche her durch den Kathodenkontakt kontaktiert ist; und
(e) innerhalb jeder MCT-Zelle auf der Kathodenseite eine MOS-Struktur vorgesehen ist, welche einen schaltbaren Kurzschluss zwischen der zweiten Basisschicht und dem Kathodenkontakt bildet.

Beim MCT können die Randkurzschlussgebiete besonders wirksam die randseitige Stromüberhöhung verhindern.

Die Integrierung der Randkurzschlussgebiete hat den Vorteil, dass diese ohne Mehraufwand bei der Herstellung der eigentlichen Zellstruktur - im Falle von MCT-Zellen gemeinsam mit den MOS-gesteuerten Kurzschlüssen der MCT-Zellen - erzeugt werden können.

Weitere Ausführungsformen ergeben sich aus den Unteransprüchen.

### KURZE BESCHREIBUNG DER ZEICHNUNG

Die Erfindung soll nachfolgend anhand von Ausführungsbeispielen, die sich speziell auf einen MCT beziehen, im Zusammenhang mit der Zeichnung näher erläutert werden. Es zeigen
- Fig. 1A: ein erstes Beispiel für ein Bauelement zur Erläuterung mit zwischen einer Gruppe von MCT-Zellen und dem Randabschlussgebiet in die zweite Basisschicht eingelassenen Randkurzschlussgebiet ;
- Fig. 1B: ein zu Fig. 1A vergleichbares, zweites Beispiel, bei welchem als Randabschluss anstelle des Randabschlussgebietes Guardringe vorgesehen sind;
- Fig. 2A: ein bevorzugtes Ausführungsbeispiel für einen MCT nach der Erfindung, bei welchem das Randkurzschlussgebiet in einer Lücke zwischen der zweiten Basisschicht und dem Randabschlussgebiet direkt in die erste Basisschicht eingelassen ist;
- Fig. 2B: ein Ausführungsbeispiel gemäss Fig. 2A, bei welchem das Randkurzschlussgebiet auf der Innenseite zusätzlich MOS-gesteuerte Kurzschlüsse aufweist, so dass insgesamt eine IGBT-Struktur entsteht;
- Fig. 3A,B: in der kathodenseitigen Draufsicht bzw. im Querschnitt ein weiteres, mit Fig. 2 vergleichbares Ausführungsbeispiel, bei welchem die IGBT-Struktur des Randkurzschlussgebietes in einzelne, inselförmige IGBT-Zellen unterteilt ist; und
- Fig. 4: in der Draufsicht ein Ausführungsbeispiel für die Ausgestaltung eines vollständigen Bauelements mit einer Vielzahl von Segmenten, die ihrerseits jeweils ein Vielzahl von MCT-Zellen umfassen, und einem Randabschluss.

### WEGE ZUR AUSFÜHRUNG DER ERFINDUNG

Die nachfolgenden Erläuterungen beziehen sich speziell auf MOS-gesteuerte Thyristoren MCTs, bei welchen die einzelnen Segmente MCT-Zellen enthalten. Es ist auch möglich die Randkurzschlussgebiete auch bei anderen abschaltbaren Leistungshalbleiter-Bauelementen vorzusehen.

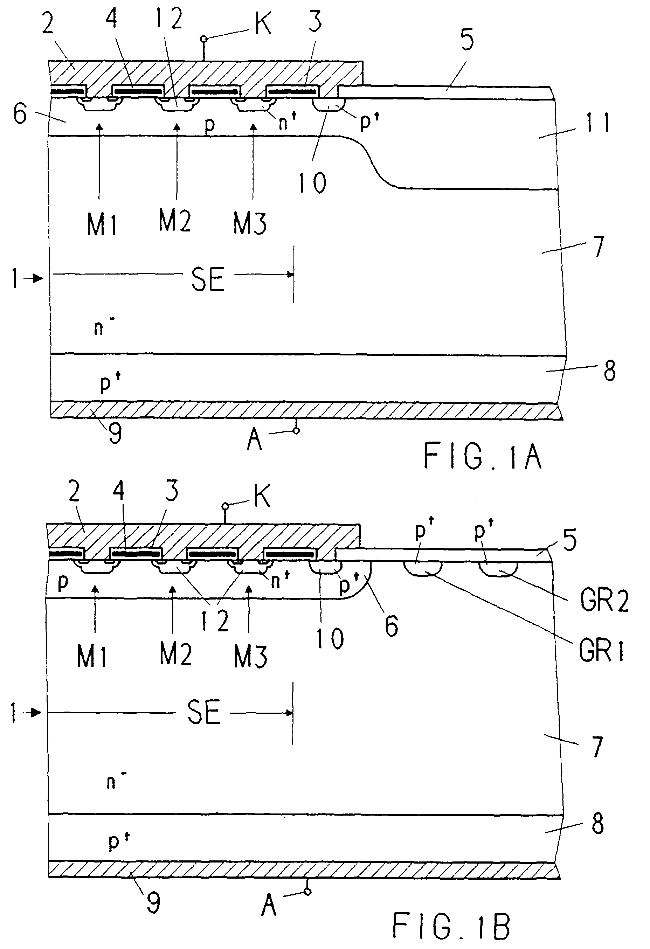

In Fig. 1A ist auschnittweise im Querschnitt der Randbereich eines MCT gemäss einem ersten Beispiel der Erfindung wiedergegeben. Das Bauelement enthält in einem Halbleitersubstrat 1 mit zwei Hauptflächen, von denen die eine einer Anode A und die andere einer Kathode K als Kathodenfläche zugeordnet ist, eine Folge von vier abwechselnd dotierten Schichten bzw. Gebieten.

Diese Folge umfasst eine (anodenseitige) Emitterschicht 8 eines ersten Leitfähigkeitstyps (hier: p⁺-dotiert), eine erste Basisschicht 7 eines zweiten, zum ersten entgegengesetzten Leitfähigkeitstyps (hier: n⁻-dotiert), eine zweite Basisschicht 6 vom ersten Leitfähigkeitstyp (hier: p-dotiert), und eine Vielzahl von (kathodenseitigen) Emittergebieten 12 des zweiten Leitfähigkeitstyps (hier: n⁺-dotiert). Die Folge bildet eine herkömmliche (p-n-p-n)-Thyristorstruktur. Die Emitterschicht 8 ist mit einem Anodenkontakt 9 in Form einer Al-Metallisierung versehen. Die Emittergebiete 12 stehen entsprechend mit einem Kathodenkontakt 2 - gleichfalls als Al-Metallisierung ausgeführt - in Verbindung.

In die Emittergebiete 12 sind kathodenseitig MOS-gesteuerte Kurzschlüsse eingelassen, die zum Abschalten den Kathodenkontakt 2 mit der ersten Basisschicht 6 kurzschliessen können. Die kathodenseitige Struktur mit den Emittergebieten und MOS-gesteuerten Kurzschlüssen ist Teil eines herkömmlichen MCT, wobei jedes Emittergebiet 12 zusammen mit den zugehörigen Kurzschlüssen eine elementare Thyristorzelle oder Einheitszelle (MCT-Zellen M1,..,M3) bildet. Die (an sich bekannte) Konfiguration der einzelnen Kurzschlüsse ist in der Fig. 1A (ebenso wie auch in Fig. 1B) aus Gründen der Uebersichtlichkeit nur angedeutet. Es kann sich dabei um DMOS-Strukturen handeln, aber auch um NMOS-Strukturen. Desgleichen können die MCT-Zellen M1,..,M3 inselförmig oder auch streifenförmig ausgebildet sein. In jedem Fall erfolgt die Ansteuerung der Kurzschlüsse über Gateelektroden 4, die, durch eine Gateisolierung 3 isoliert, oberhalb der Kathodenfläche des Halbleitersubstrats 1 angeordnet sind.

Die einzelnen, direkt nebeneinanderliegenden MCT-Zellen M1,..,M3 bilden eine zusammenhängende Zellengruppe, ein Segment SE, welches eine grössere Fläche des Halbleitersubstrats 1 überdeckt. Probleme ergeben sich im Stand der Technik nun an den Randbereichen einer solchen Zellengruppe, wo besonders starke Ueberhöhungen in der Stromdichte auftreten, die dann zu einer besonderen Belastung der MCT-Zellen im Randbereich führen. Gemäss der Erfindung ist es vorgesehen, jede Zellengruppe in lateraler Richtung an ihrem Rand mit Randkurzschlussgebieten 10 vom ersten Leitfähigkeitstyp (hier: p⁺-dotiert) zu umgeben, die von der Kathodenfläche her in das Halbleitersubstrat 1 hineinragen und mit dem Kathodenkontakt 2 leitend verbunden sind.

Beim Beispiel der Fig. 1A (ebenso wie auch beim Beispiel der Fig. 1B) sind die Randabschlussgebiete 10 direkt in die zweite Basisschicht 6 eingelassen. Sie können dabei entweder als eine Vielzahl von inselförmigen Zellen oder aber auch streifenförmig ausgebildet sein. Die zweite Basisschicht 6 geht bei diesem Ausführungsbeispiel im Uebrigen ausserhalb der Randkurzschlussgebiete 10 in ein - ebenfalls p-dotiertes Randabschlussgebiet 11 über, das an sich für hochsperrende Bauelemente aus dem Stand der Technik bekannt ist.

Die in Fig. 1A dargestellte Konfiguration bietet eine besonders einfache Lösung des Problems der randseitigen Stromüberhöhung: Da die hohe Randstromdichte hauptsächlich von Löchern getragen wird, reicht die gezeigte Anordnung der p+-Randkurzschlussgebiete 10 in Form von Zellen oder Streifen entlang der Kathodenperipherie aus, um diese Ladungsträger aus dem Bauelement zu extrahieren und so die emissionsfähigen MCT-Zellen M1,..,M3 zu entlasten. An dieser Stelle sei darauf hingewiesen, dass die Randkurzschlussgebiete 10 ohne Mehraufwand bei der Herstellung der eigentlichen MCT-Struktur (gemeinsam mit den MOS-gesteuerten Kurzschlüssen in den MCT-Zellen) mit erzeugt werden können.

Als eigentlicher Randabschluss des gesamten Bauelements ist in Fig. 1A ein tiefer eindiffundiertes Randabschlussgebiet 11 vorgesehen, welches durch eine Randpassivierung 5 z.B. aus SiO₂ abgedeckt ist. Anstelle eines solchen Randabschlussgebietes 11 können im Rahmen der Erfindung natürlich auch andere bekannte Arten von Randabschlüssen verwendet werden, wie z.B. Mesa-geätzte Randstrukturen, Guardringe, Bevel-Konfigurationen oder dergleichen. Eine zu Fig. 1A vergleichbare Ausführungsform, bei der anstelle des Randabschlussgebietes 11 beispielsweise einzelne, p⁺-dotierte Guardringe GR1 und GR2 vorgesehen sind, ist zur Verdeutlichung dieser Variationsmöglichkeiten in Fig. 1B dargestellt.

Die in Fig. 1A und 1B gezeigten Strukturen sind zwar besonders einfach aufgebaut und herstellbar, haben aber auch einen Nachteil: Der Kurzschluss der Emittergebiete 12 ist in seiner Wirkung so effektiv, dass eine beträchtliche Anzahl von MCT-Zellen keine Elektronen emittieren kann. Die Zellen können somit nicht zur Stromleitung beitragen und verringern damit die effektive Emitterfläche.

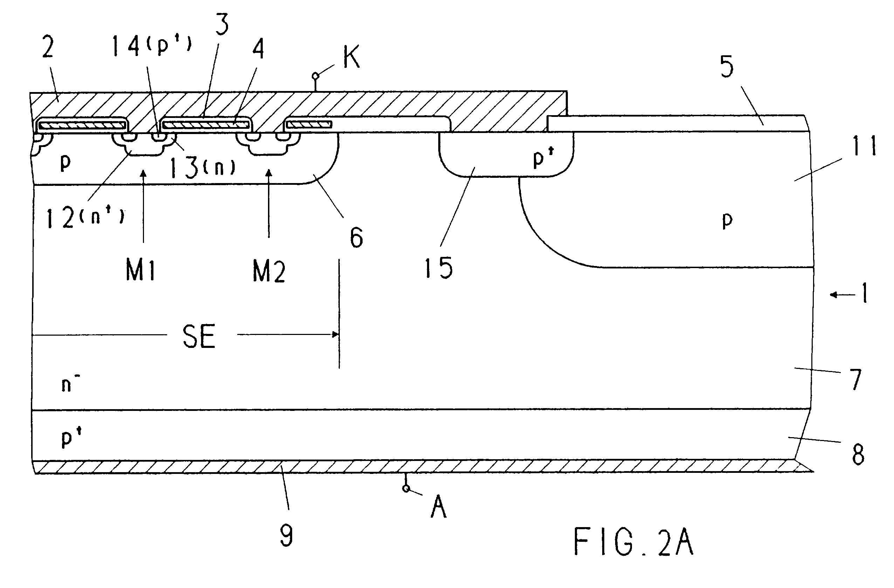

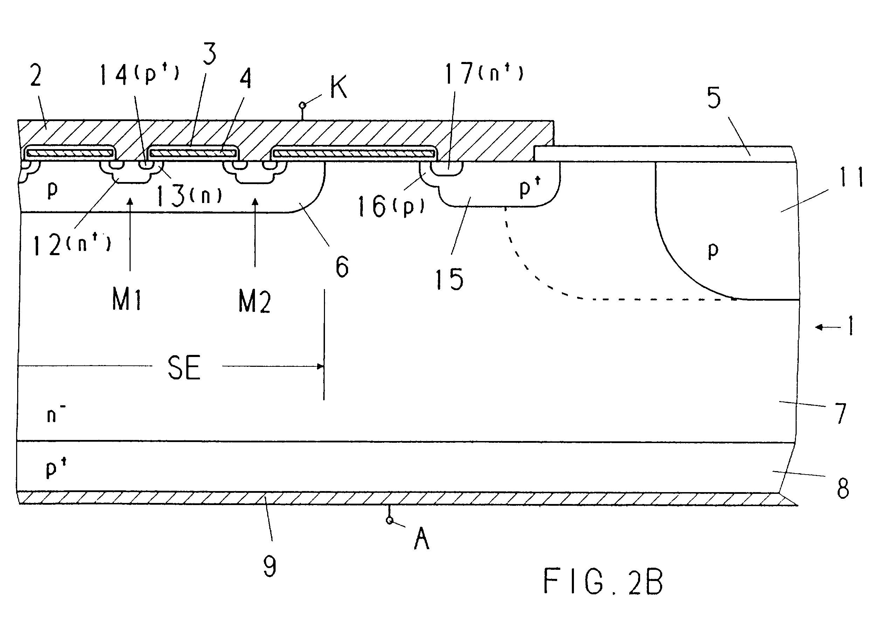

Dieses Problem kann weitgehend mit den in Fig. 2 A und B dargestellten Strukturen gelöst werden. Hier werden zunächst die zu den Gebieten 10 aus Fig. 1A und 1B analogen Randkurzschlussgebiete 15 aus der zweiten Basisschicht 6 herausgenommen und in einen Zwischenraum zwischen der zweiten Basisschicht 6 und dem Randabschlussgebiet 11 gelegt, wobei die Randkurzschlussgebiete 15 mit dem Randabschlussgebiet 11 entweder überlappen (Fig. 2A und gestrichelte Linie in Fig. 2B) oder von diesem getrennt sind (durchgezogene Randlinie von 11 in Fig. 2B). In dem Zwischenraum tritt dabei die erste Basisschicht 7 an die Kathodenfläche. Die Randkurzschlussgebiete 15 sind auf diese Weise direkt in die erste Basisschicht 7 eingelassen.

In Fig. 2A sind die Randkurzschlussgebiete 15 ohne zusätzliche Strukturen ausgeführt. Ein Einschalten ist hier auch über den p-Basisrand möglich.

In Fig. 2B sind innerhalb der Randkurzschlussgebiete 15 zur Kathodenfläche hin zusätzlich MOS-gesteuerte Kurzschlüsse integriert, welche eine schaltbare Verbindung zwischen dem Kathodenkontakt 2 und der ersten Basisschicht 7 herstellen, und zusammen mit den Randkurzschlussgebieten 15, der ersten Basisschicht 7 und der Emitterschicht 8 IGBT-Strukturen (IGBT = Insulated Gate Bipolar Transistor) bilden. Die Kurzschlüsse selbst umfassen jeweils ein n⁺-dotiertes Sourcegebiet 17, ein p-dotiertes Kanalgebiet 16, die erste Basisschicht 7, sowie die über dem Kanalgebiet 16 isoliert angeordnete Gate-elektrode 4 (eine vergleichbare, aber komplementäre Konfiguration haben die MOS-gesteuerten Kurzschlüsse in den MCT-Zellen M1, M2, die in Fig. 2 eingehender dargestellt sind und jeweils ein n-dotiertes Kanalgebiet 13 und ein p⁺-dotiertes Kathodenkurzschlussgebiet 14 als Sourcegebiet umfassen).

Die IGBT-Strukturen werden in den Randkurzschlussgebieten 15 vorzugsweise nur auf der Innenseite, d.h. zur aktiven Fläche des Bauelements hin, angeordnet. Die Anordnung der unterschiedlichen Elemente innerhalb der Randstruktur ist nämlich nicht trivial: Zunächst repräsentieren die Randkurzschlussgebiete 15 durch die Kontaktierung mit dem Kathodenkontakt 2 einen Kathodenkurzschluss. Dieser Kurzschluss umrandet die gesamte Peripherie des MCT. Wie bereits bemerkt, wird dieser Kathodenkurzschluss einige MCT-Zellen inaktivieren. Durch die integrierte IGBT-Funktion, welche in der Lage ist, Elektronen zu spenden, kann der Mangel der MCT-Zellen an Elektronen mit Hilfe eines positiven Gatesignals abgebaut werden.

Es ist hierbei daran gedacht, das Gatesignal auch während des eingeschalteten Zustandes aufrechtzuerhalten. Selbstverständlich kann das gesamte Bauelement auch mit einem positiven Gatesignal aus einem Blockierzustand eingeschaltet werden. Diese Lösung ist besonders elegant für grossflächige MCTs, welche aus einer grossen Anzahl von Segmenten SE aufgebaut werden. Jedes Segment SE hat eine Fläche von typischerweise 1 bis 2 mm² und ist von den beschriebenen Randkurzschlussgebieten 15 mit integriertem IGBTs umgeben. Bei einer solchen kleinen Fläche ist kein weiterer Aufwand für das Einschalten notwendig.

Bei dieser Anwendung der IGBTs darf man das diesen Bauelementen inhärente Latch-up-Problem nicht vergessen: in Gegenwart hoher Stromdichten neigt der IGBT dazu, in einen parasitären Thyristor-artigen Betriebszustand zu fallen. In der hier betrachteten Situation kommt hinzu, dass ja gerade aus dem Aussenraum hohe Stromdichten auf die Kathodenperipherie zuströmen. In der Anordnung nach Fig. 2 wird angestrebt, dass diese Ströme bereits an der Aussenkante der Randkurzschlussgebiete 15 einströmen. so dass die IGBT-Struktur auf der Innenseite ihre Funktion ungestört - quasi im Windschatten - erfüllen kann. Es wäre daher ungünstig, IGBT-Strukturen auf der Innen- und Aussenkante der Randkurzschlussgebiete 15 anzuordnen.

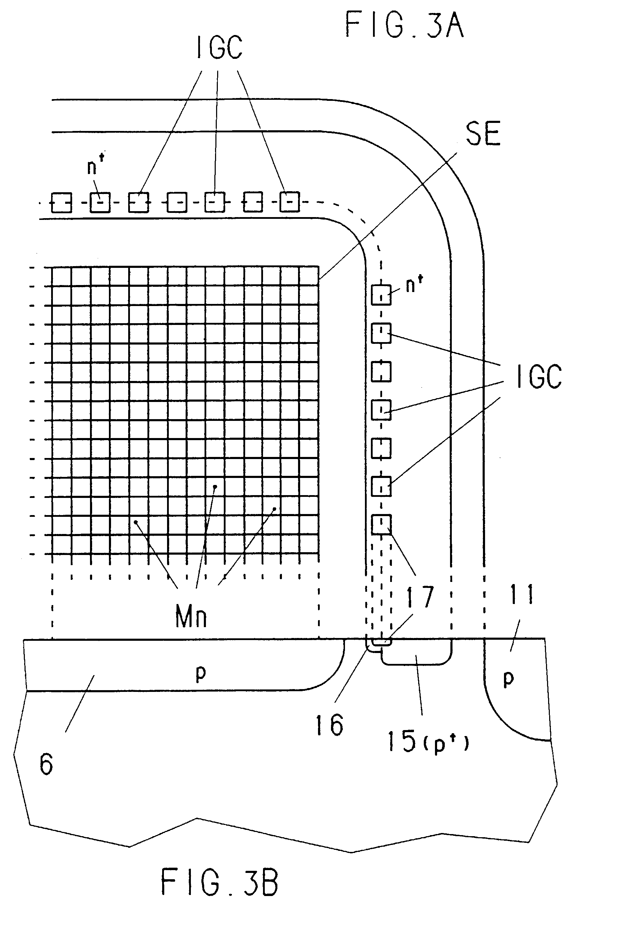

Um das genannte Latch-up-Problem noch weiter zu entschärfen, ist es vorteilhaft, die n⁺-dotierten Sourcegebiete 17 der IGBT-Struktur nicht kontinuierlich mit den Randkurzschlussgebieten 15 umlaufen zu lassen, sondern sie periodisch zu unterbrechen, so dass sie inselförmig ausgebildet sind. Eine solche Ausführungsform ist in Fig. 3A in der kathodenseitigen Draufsicht, und in Fig. 3B im zugehörigen Querschnitt wiedergegeben. Die einzelnen Sourcegebiete 17 definieren dann einzelne IGBT-Zellen IGC, die von ähnlicher Gestalt sind wie die von ihnen umgebenen MCT-Zellen Mn.

Die auf diese Weise geschaffenen Kanäle zwischen den IGBT-Zellen IGC erlauben eventuell vorhandenen Löchern, auch von der Innenseite her direkt in das Randkurzschlussgebiet 15 zu gelangen. Dies ist eine Voraussetzung, um das Latch-up zu verhindern. In einer weiteren, nicht gezeigten Ausführungsform ist es denkbar, an die rahmenförmigen Randkurzschlussgebiete im Aussenraum - wie in Fig. 1B angedeutet - Guardringe anzuschliessen oder diese auch mit einer Feldplattentechnik zu verknüpfen.

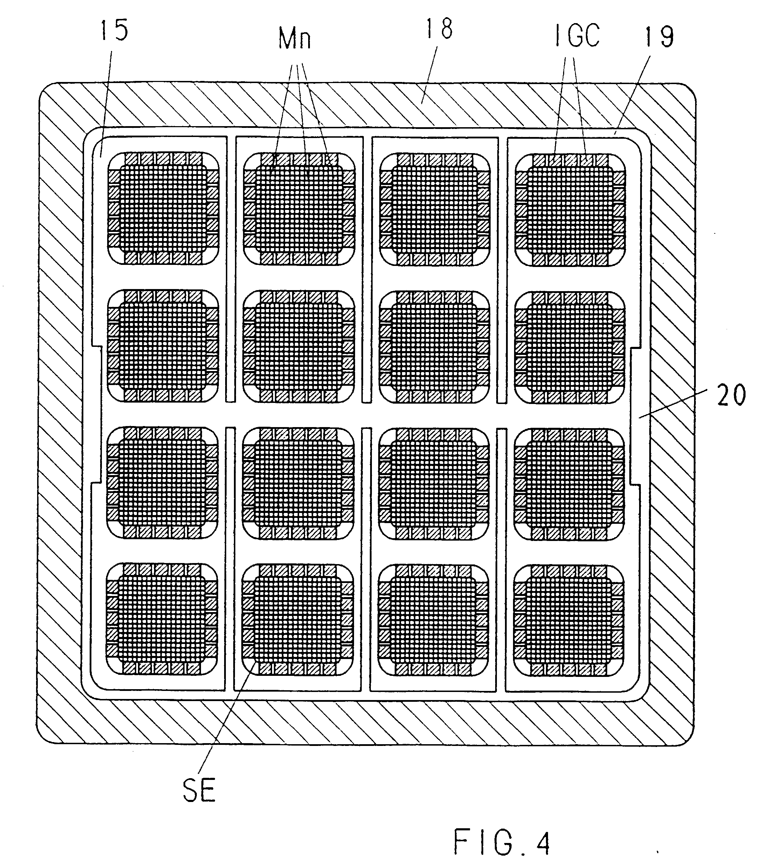

Ein vollständiges Bauelement der in Fig. 3A und B dargestellten Art ist schliesslich in der Draufsicht in Fig. 4 wiedergegeben. Die aktive Fläche ist hier in eine Vielzahl von (sechzehn) Segmenten SE unterteilt, die jeweils mehrer 100 bis einige 1000 MCT-Zellen Mn enthalten. Die Segmente SE sind von dem Randkurzschlussgebiet 15 gitterförmig umgeben. An dass Randkurzschlussgebiet 15 schliesst aussen ein herkömmlicher Randabschluss 18 an, der das gesamte Bauelement berandet. Eine von der Kathode K getrennte Gatemetallisierung 19 umschliesst das Bauelement als Ganzes und weist an bestimmten Stellen Bonding Pads 20 in Form von Verbreiterungen auf, die für den elektrischen Anschluss der Gates vorgesehen sind.

Insgesamt ergibt sich mit der Erfindung ein MCT, bei dem die am Rande der aktiven Fläche auftretenden Stromdichteüberhöhungen auf ein unschädliches Mass reduziert bzw. ganz beseitigt sind.

## Patentansprüche

1. MOS-gesteuerter Thyristor MCT, umfassend
(a) ein Halbleitersubstrat (1) mit zwei gegenüberliegenden Hauptflächen, von denen die eine einer Anode (A) zugeordnet ist, und die andere einer Kathode (K) zugeordnet ist und eine Kathodenfläche bildet;
(b) innerhalb des Halbleitersubstrats (1) zwischen der Anode (A) und der Kathode (K) eine Schichtenfolge mit einer p+ dotierten Emitterschicht (8), einer ersten, n⁻ dotierten Basisschicht (7), und einer zweiten, p dotierten Basisschicht (6); und
(c) innerhalb des Halbleitersubstrats (1) zwischen der Anode (A) und der Kathode (K) eine Vielzahl von nebeneinander angeordneten und parallel geschalteten, abschaltbaren MCT-Einheitszellen, wobei jeweils eine Mehrzahl von Einheitszellen zu einer Zellengruppe zusammengefasst sind und ein Segment (SE) bilden und in dem Bauelement mindestens zwei Segmente vorgesehen sind, wobei die zweite Basisschicht in ihrer lateralen Ausdehnung jeweils auf ein Segment (SE) beschränkt ist, und
(d) jedes Segment (SE) in lateraler Richtung an seinem Rand vollständig von Randkurzschlussgebieten (10, 15) umgeben ist, welche Randkurzschlussgebiete (10, 15) von der Kathodenfläche her in das Halbleitersubstrat (1) eingelassen, mit einem auf der Kathodenfläche angeordneten Kathodenkontakt (2) leitend verbunden sind und p+ und damit wesentlich höher dotiert sind als die zweite Basisschicht (6).

2. Bauelement nach Anspruch 1, dadurch gekennzeichnet, dass
(a) innerhalb jeder MCT-Zelle (M1,..,M3; Mn) auf der Kathodenseite ein in die zweite Basisschicht (6) eingelassenes ist dotiertes Ermittergebiet (12), welches von der Kathodenfläche her durch den Kathodenkontakt (2) kontaktiert ist; und
(b) innerhalb jeder MCT-Zelle (M1,..,M3; Mn) auf der Kathodenseite eine MOS-Struktur vorgesehen ist, welche einen schaltbaren Kurzschluss zwischen der zweiten Basisschicht (6) und dem Kathodenkontakt (2) bildet.

3. Bauelement nach Anspruch 2, dadurch gekennzeichnet, dass
(a) die zweite Basisschicht (6) ausserhalb der Segmente (SE) die erste Basisschicht (7) an die Kathodenfläche tritt; und
(b) die Randkurzschlussgebiete (15) in die erste Basisschicht (7) eingelassen sind.

4. Bauelement nach Anspruch 3, dadurch gekennzeichnet, dass innerhalb der Randkurzschlussgebiete (15) MOS-gesteuerte Kurzschlüsse (4, 15, 16. 17) vorgesehen sind, welche eine schaltbare Verbindung zwischen dem Kathodenkontakt (2) und der ersten Basisschicht (7) herstellen und zusammen mit den Randkurzschlussgebieten (15), der ersten Basisschicht (7) und der Emitterschicht (8) IGBT-Strukturen bilden.

5. Bauelement nach Anspruch 4, dadurch gekennzeichnet, dass die MOS-gesteuerten Kurzschlüsse (4, 15, 16, 17) nur auf den den Segmenten zugewandten Seiten der Randkurzschlussgebiete (15) angeordnet sind.

6. Bauelement nach Anspruch 5, dadurch gekennzeichnet, dass
(a) die MOS-gesteuerten Kurzschlüsse in den IGBT-Strukturen Kanalgebiete (16) vom p-Typ und Sourcegebiete (17) vom n-Typ umfassen; und
(b) die Sourcegebiete (17) inselförmig ausgebildet sind und eine Vielzahl von einzelnen IGBT-Zellen (IGC) definieren.

7. Bauelement nach einem der Ansprüche 1 bis 6, dadurch gekennzeichnet, dass die Randkurzschlussgebiete (10, 15) inselförmig oder als durchgehende Streifen ausgebildet sind.

8. Bauelement nach einem der Ansprüche 1 bis 6, dadurch gekennzeichnet, dass die Randkurzschlussgebiete (10, 15) ein Gitter bilden, welches die einzelnen Segmente (SE) umgibt.

9. Bauelement nach einem der Ansprüche 1 bis 8, dadurch gekennzeichnet, dass
(a) ausserhalb der Randkurzschlussgebiete (10, 15) ein Randabschluss (18) vorgesehen ist, welcher die Form eines Randabschlussgebiets (11), von Guardringen (GR1, GR2) annehmen kann; und
(b) die von den Segmenten (SE) gebildete aktive Fläche auf der Kathodenseite aussen von einer Gatemetallisierung (19) umschlossen ist, welche von der Kathode (K) getrennt ist.

## Claims

1. MOS-controlled thyristor MCT comprising
(a) a semiconductor substrate (1) having two oppositely situated principal faces, of which one is assigned to an anode (A) and the other is assigned to a cathode (K) and forms a cathode surface;
(b) between the anode (A) and cathode (K) inside the semiconductor substrate (1), a layer sequence comprising a p⁺-doped emitter layer (8), a first, n⁻-doped base layer (7), and a second, p-doped base layer (6); and
(c) between the anode (A) and the cathode (K) inside the semiconductor substrate (1) a multiplicity of adjacently disposed turn-off MCT unit cells connected in parallel, a multiplicity of unit cells being combined in each case into a group of cells and forming a segment (SE) and at least two segments being provided in the device, the lateral extent of the second base layer being limited in each case to one segment (SE), and
(d) each segment (SE) is completely surrounded at its periphery in the lateral direction by peripheral short-circuit regions (10, 15) which are embedded in the semiconductor substrate (1) from the cathode surface, are conductively connected to a cathode contact (2) disposed on the cathode surface and are p+ and thus substantially more highly doped than the second base layer (6).

2. Device according to Claim 1, characterized in that
(a) an n⁺-doped emitter region (12) which is embedded in the second base layer (6) and to which contact is made from the cathode surface by the cathode contact (2), [lacuna] inside each MCT cell (M1,.., M3; Mn) on the cathode side; and
(b) an MOS structure, which forms a switchable short circuit between the second base layer (6) and the cathode contact (2), is provided inside each MCT cell (M1,.., M3; Mn) on the cathode side.

3. Device according to Claim 2, characterized in that
(a) the second base layer (6) [sic] outside the segments (SE), the first base layer (7) emerges at the cathode surface; and
(b) the peripheral short-circuit regions (15) are embedded in the first base layer (7).

4. Device according to Claim 3, characterized in that MOS-controlled short circuits (4, 15, 16, 17), which make a switchable connection between the cathode contact (2) and the first base layer (7) and, together with the peripheral short-circuit regions (15), the first base layer (7) and the emitter layer (8) form IGBT structures, are provided inside the peripheral short-circuit regions (15).

5. Device according to Claim 4, characterized in that the MOS-controlled short circuits (4, 15, 16, 17) are disposed only on the sides of the peripheral short-circuit regions (15) facing the segments.

6. Device according to Claim 5, characterized in that
(a) the MOS-controlled short circuits in the IGBT structures comprise channel regions (16) of the p-type and source regions (17) of the n-type; and
(b) the source regions (17) are of insular construction and define a multiplicity of separate IGBT cells (IGC).

7. Device according to any of Claims 1 to 6, characterized in that the peripheral short-circuit regions (10, 15) are of insular construction or are constructed as continuous strips.

8. Device according to any of Claims 1 to 6, characterized in that the peripheral short-circuit regions (10, 15) form a grid which surrounds the separate segments (SE).

9. Device according to any of Claims 1 to 8, characterized in that
(a) a peripheral termination (18), which may assume the form of a peripheral termination region (11), of guard rings (GR1, GR2) is provided outside the peripheral short-circuit regions (10, 15); and
(b) the active area formed by the segments (SE) on the cathode side is surrounded on the outside by a gate metallization (19) which is separated from the cathode (K).

## Revendications

1. Thyristor commandé par MOS MCT comprenant
(a) un substrat semiconducteur (1) ayant deux surfaces principales opposées, l'une d'entre elles étant associée à une anode (A) et l'autre étant associée à une cathode (K) et formant une surface de cathode ;
(b) à l'intérieur du substrat semiconducteur (1), entre l'anode (A) et la cathode (K), une série de couches composée d'une couche d'émetteur (8) dopée p+, d'une première couche de base (7) dopée n- et d'une deuxième couche de base (6) dopée p ; et
(c) à l'intérieur du substrat semiconducteur (1), entre l'anode (A) et la cathode (K), une pluralité de cellules MCT individuelles disposées les unes à côté des autres et branchées en parallèle, plusieurs cellules individuelles étant à chaque fois regroupées en un groupe de cellules et formant ainsi un segment (SE) et au moins deux segments étant prévus dans le dispositif, la deuxième couche de base étant à chaque fois limitée par un segment (SE) dans son extension latérale ; et
(d) chaque segment (SE) est entièrement entouré dans la direction latérale au niveau de son bord par des zones de court-circuit périphériques (10, 15), lesquelles zones de court-circuit périphériques (10, 15) pénètrent dans le substrat semiconducteur (1) à partir de la surface de cathode, sont reliées électriquement avec un contact de cathode (2) disposé sur la surface de cathode et sont dopées p+, c'est-à-dire nettement plus que la deuxième couche de base (6).

2. Dispositif selon la revendication 1, caractérisé par le fait que
(a) une zone d'émetteur (12) dopée n+ qui pénètre dans la deuxième couche de base (6) est disposée à l'intérieur de chaque cellule MCT (M1, .., M3 ; Mn) du côté de la cathode, laquelle zone est mise en contact par le contact de cathode (2) à partir de la surface de cathode ; et
(b) une structure MOS est prévue à l'intérieur de chaque cellule MCT (M1, .., M3 ; Mn) du côté de la cathode, laquelle structure forme un court-circuit commandable entre la deuxième couche de base (6) et le contact de cathode (2).

3. Dispositif selon la revendication 2, caractérisé par le fait que
(a) la deuxième couche de base (6) vient rencontrer la première couche de base (7) au niveau de la surface de cathode à l'extérieur des segments (SE); et
(b) les zones de court-circuit périphériques (15) sont incorporés dans la première couche de base (7).

4. Dispositif selon la revendication 3, caractérisé par le fait que des courts-circuits à commande MOS (4, 15, 16, 17) sont prévus à l'intérieur des zones de court-circuit périphériques (15), lesquels réalisent une liaison commandable entre le contact de cathode (2) et la première couche de base (7) et, combinés avec les zones de court-circuit périphériques (15), la première couche de base (7) et la couche d'émetteur (8), forment des structures IGBT.

5. Dispositif selon la revendication 4, caractérisé par le fait que les courts-circuits à commande MOS (4, 15, 16, 17) ne sont disposés que sur les côtés des zones de court-circuit périphériques (15) qui sont dirigés vers les segments.

6. Dispositif selon la revendication 5, caractérisé par le fait que
(a) les courts-circuits à commande MOS dans les structures IGBT comprennent des zones de canal (16) de type p et des zones de source (17) de type n ; et
(b) les zones de source (17) sont réalisées sous la forme d'îlots et définissent une pluralité de cellules IGBT (IGC) individuelles.

7. Dispositif selon l'une des revendications 1 à 6, caractérisé par le fait que les zones de court-circuit périphériques (10, 15) sont réalisées sous la forme d'îlots ou de bandes continues.

8. Dispositif selon l'une des revendications 1 à 6, caractérisé par le fait que les zones de court-circuit périphériques (10, 15) forment une grille qui entoure chacun des segments (SE).

9. Dispositif selon l'une des revendications 1 à 8, caractérisé par le fait que
(a) une terminaison périphérique (18) est prévue en dehors des zones de court-circuit périphériques (10, 15), laquelle peut prendre la forme d'une zone de terminaison périphérique (11), d'anneaux de garde (GR1, GR2) ; et
(b) la surface active du côté cathode formée par les segments (SE) est entourée à l'extérieur par une métallisation de gâchette (19) qui est isolée de la cathode (K).
